# EUROPÄISCHE PATENTSCHRIFT

(11) **EP 2 612 125 B1**
(45) Veröffentlichungstag und Bekanntmachung des Hinweises auf die Patenterteilung: **14.01.2015**
(21) Anmeldenummer: 11751529.6
(22) Anmeldetag: 29.08.2011
(51) Int. Cl.: G01L 19/14, G01L 19/00

(54) **DRUCKSENSOR MIT PIEZORESISTIVEM SENSORCHIP-ELEMENT**
PRESSURE SENSOR HAVING A PIEZORESISTIVE SENSOR CHIP ELEMENT
CAPTEUR DE PRESSION COMPRENANT UN ÉLÉMENT DE PUCE DE DÉTECTION PIÉZORÉSISTIF

(30) Priorität: 13.09.2010 CH 14622010; 01.09.2010 US 379072 P
(43) Veröffentlichungstag der Anmeldung: 10.07.2013
(73) Patentinhaber: Kistler Holding AG, 8408 Winterthur (CH)
(72) Erfinder: ALBICKER, Ulrich, 79787 Lauchringen (DE); SONDEREGGER, Christof, CH-8413 Neftenbach (CH); MEISTER, Peter, CH-8413 Neftenbach (CH); VON BERG, Jochen, CH-8413 Neftenbach (CH); TANNER, René, CH-8472 Seuzach (CH); SCHNELLINGER, Jeffrey, M., Akron New York 14001-1056 (US)
(86) Internationale Anmeldenummer: PCT/CH2011/000196
(87) Internationale Veröffentlichungsnummer: WO 2012/027853

(56) Entgegenhaltungen:
- EP-A1- 1 584 911
- JP-A- 61 226 627
- US-B1- 6 543 292

## Beschreibung

### Technisches Gebiet

Die Erfindung betrifft einen Drucksensor mit abgeschlossener Chipkavität umfassend ein piezoresistives Sensorchip-Element zum Messen des Drucks eines den Chip umspülenden Druckmediums mit einer Element-Unterseite, sowie einen Träger mit einer Träger-Oberseite, auf der das Sensorchip-Element an seiner Unterseite befestigt ist, wobei diese Unterseite aus einem Haftbereich besteht und einen äusseren Rand aufweist, und wobei die Unterseite im Haftbereich an der Träger-Oberseite haftet.

### Stand der Technik

Piezoresistive Drucksensoren unterscheiden sich von anderen, insbesondere von piezoelektrischen Drucksensoren dadurch, dass sie über sehr lange Zeiten Drücke zuverlässig messen können. Piezoelektrische Drucksensoren brauchen jeweils ein "Reset" um wieder startbereit zu sein für eine neue Messungen, da sie mit der Zeit an Ladung verlieren und "driften".

Beispiele für Absolutdrucksensoren sind piezoresistive Sensoren, insbesondere ölgefüllte piezoresistive Drucksensoren. Sie umfassen ein Sensorchip-Element, welches auf einem Träger oder auf einer Durchführung angebracht ist. In der Regel wird dieses mit einem Kleber aufgeklebt. Das Sensorchip-Element wird schliesslich unter einer Membrane von Öl umspült. Wenn ausserhalb der Membrane ein Druck angebracht wird, so wird das Öl unter der Membrane ebenfalls unter Druck gesetzt. Der Sensorchip erzeugt unter Druck ein entsprechendes Signal, welches schliesslich durch zwei oder mehr Kontaktierungen mit anschliessenden Leitungen zu einem Auswertegerät geleitet wird. Solche Sensoren können durchaus auch ohne Membranen ausgestaltet sein. Der Sensorchip ist dann direkt dem äusseren Druckmedium ausgesetzt.

Es hat sich gezeigt, dass hier beschriebene Sensoren mit der Zeit auch einer Signaldrift unterliegen. Dies bedeutet, dass sich der angegebene Druck mit der Zeit bei gleicher Belastung leicht verändert. Diese Drift ist viel geringer als jene bei piezoelektrischen Drucksensoren, da sie eine andere physikalische Ursache hat. Piezoelektrische Elemente verlieren mit der Zeit an Ladung, piezoresistive nicht. Die Drift bei piezoresistiven Drucksensoren liegt bei etwa 0.1%.

Der Druck wirkt gleichermassen auch auf die Oberfläche des Trägers oder der Durchführung, auf der mittig das Sensorchip-Element angebracht wird. Insbesondere bei hohem Druck von mehr als 50 bar biegt sich die Durchführung etwas durch, sodass mittig unter dem Sensorchip-Element eine leichte Mulde entsteht. Es hat sich gezeigt, dass der Kleber zwischen der Durchführung und dem Sensorchip-Element nach einiger Zeit nach innen kriecht, um diese Mulde zu füllen. Zudem kann der Kleber durch den Druck im Randbereich von Sensorchip-Element und Träger gestaucht werden, wodurch das Sensorchip-Element deformiert wird. Dieses Stauchen gleicht sich durch Kriechen des Klebers nach einiger Zeit aus. Dies führt zu einer Signaldrift, weil sich die Bedingungen des Gegendrucks von unten an das Sensorchip-Element mit der Zeit ändern.

Um das Problem zu beheben wurde in einigen Fällen auf die Klebung verzichtet. Das Sensorchip-Element war dann lediglich an den Kontaktierungen befestigt. Erschütterungen zerstörten aber manchmal diese Kontaktierungen, wodurch der Sensor keine Messwerte mehr übermitteln konnte.

Aus der US 6543292 ist ein rechteckiges Sensorchip-Element bekannt, das an jeder der vier unteren Ecken durch einen Kleber-Tropfen mit einem Träger verbunden ist. Dadurch sollen thermische Spannungen zwischen Träger und Chip vermieden werden. Es hat sich aber gezeigt, dass durch die Kapillarwirkung im Spalt zwischen Sensorchip-Element Unterseite und Träger-oberseite der Kleber in diesem Spalt verläuft, entweder bereits beim Auftragen oder während dem späteren Einsatz. Dadurch kann sich der Kleber über eine weite Fläche des Spaltes verteilen, allenfalls sogar den gesamten Spaltraum ausfüllen. Die Grössen der durch die Klebe-Tropfen bedeckten Flächen sind nicht kontrollierbar. Das erwähnte Problem der Signaldrift ist somit nicht behoben, die Sensorchip-Elemente können auch in dieser Applikation gestaucht werden.

Auch bei der Verwendung von pastösen Klebern, die kaum eine Kapillarwirkung aufweisen, ist die Montage schwierig. Der Druck, mit welchem das Sensorchip-Element 2 an den Kleber angebracht wird, ist nicht vollständig zu kontrollieren. Der Kleber wird daher unkontrolliert unter das Element 2 gequetscht, ohne dass festgestellt werden kann, wie weit der Haftbereich gegen die Mitte des Elements 5 vordringt.

Abgesehen von den diese Erfindung betreffenden Absolutdrucksensoren sind auch Differenzdrucksensoren bekannt. Im Gegensatz zu den Absolutdrucksensoren ist die Chipkavität der Differenzdrucksensoren nicht geschlossen sondern mit einem zweiten Druckmedium in Druckverbindung. Da das Element den Differenzdruck zwischen dem Umgebungsdruck und dem Kavitätsdruck ermittelt, erfährt der Träger selbst keine Last. Ein solches Beispiel ist in der JP 61-226627 angegeben. Das Element wird mit Klemmen befestigt, die dieses durch eine Federkraft fixieren. Da kein Kleber verwendet wird, kann auch keine Stauchung des Elements erfolgen.

### Darstellung der Erfindung

Die Aufgabe der Erfindung ist es daher, eine neuartige Befestigung für das Sensorchip-Element in einem piezoresistiven Drucksensor oben beschriebener Art zu beschreiben, welche keine Signaldrift zur Folge hat und welches die Kontaktierungen bei Erschütterungen nicht zusätzlich belastet.

Die Aufgabe wird durch die Merkmale im unabhängigen Anspruch gelöst. Die abhängigen Ansprüche beziehen sich auf besonders vorteilhafte Ausführungsformen der Erfindung.

Die Erfindung betrifft somit einen Drucksensor eingangs beschriebener Art, wobei die Element-Unterseite einen Nichthaftbereich aufweist, und wobei die Unterseite im Nichthaftbereich nicht an der Träger-Oberseite haftet. Der Nichthaftbereich erstreckt sich mindestens über eine mittig auf der Unterseite angeordnete Kreisfläche, welche einen Drittel der Gesamtfläche der Element-Unterseite umfasst. Zudem umfasst der Nichthaftbereich mindestens einen Verbindungsbereich von dieser mittigen Fläche zum Rand der Unterseite. Dadurch kann sich der Druck im Druckmedium durch den Verbindungsbereich in einen Raum unter dem Nichthaftbereich auf der Element-Unterseite ausbreiten.

Erfindungsgemäss weist der Träger des Drucksensors mittig unter dem Sensorchip-Element eine Vertiefung auf. Eine solche Vertiefung kann leicht als Bohrung angebracht werden. Dadurch ist gewährleistet, dass der Haftbereich höchstens den Bereich der Träger-Oberseite umfasst, der nicht gegenüber dieser Vertiefung angeordnet ist. Der Nichthaftbereich umfasst entsprechend mindestens den Bereich der Vertiefung, der der Element-Unterseite gegenüberliegt. Er bildet dann mindestens die gemeinsame Fläche von Vertiefung und Element-Unterfläche.

Der Kleber kann sich durch die Kapillarwirkung nicht auf den mittleren Bereich der Unterseite des Sensorchip-Elements ausbreiten, weil der Vertiefungsbereich dort einen dafür zu grossen Abstand zur Träger-Oberseite bildet.

Die Vertiefung soll sich mindestens über eine mittig auf der Unterseite angeordnete Kreisfläche erstrecken, welche einen Drittel der Gesamtfläche der Element-Unterseite umfasst. Zudem soll die Vertiefung mindestens einen Verbindungsbereich von der Kreisfläche über den Rand der Unterseite hinaus umfassen, sodass sich der Druck im Druckmedium durch den Verbindungsbereich in einen Raum unter dem Nichthaftbereich auf der Element-Unterseite ausbreiten kann.

Dadurch, dass die Vertiefung an mindestens einer Stelle über den Rand der Unterseite hinausragt, wird eine Art Tunnel geschaffen, durch den das Druckmedium stets Zugang zum mittleren Bereich der Element-Unterseite hat.

Durch diese Anordnung kann der Druck allseitig gegen das Sensorchip-Element wirken, auch von unten. Entscheidend ist aber, dass der Haftbereich nicht im mittleren Bereich des Sensorchip-Elements ist. Es hat sich gezeigt, dass eine mittige Verbindung zwischen Träger und Sensorchip-Element eine Verformung des Sensorchip-Elements zur Folge haben kann, wenn sich der Träger selbst unter der hohen Last eines beaufschlagten Drucks durchbiegt. Eine derartige Verformung ist an sich noch kein Problem, da diese bei der Eichung des Drucksensors ebenfalls wirkt.

Nach langer Zeit unter permanent hohem Druck verliert die mittlere Verbindung aber an Spannkraft, da die Haftung in der Regel langsam nachlässt. Dadurch verformt sich das Sensorchip-Element langsam wieder in seine Ausgangsform, was sich in der Datenausgabe des Messelements fälschlicherweise als Druckänderung äussert.

Eine erfindungsgemässe Anbringung des Sensorchip-Elements an den Träger erlaubt es, dass das Sensorchip-Element stets seine ursprüngliche Form behält und durch eine Verformung der Oberseite des Trägers selbst nicht verformt wird. Der Haftbereich, der weniger als zwei Drittel, vorzugsweise weniger als ein Drittel der gesamten Unterseite des Sensorchip-Elements ausmacht, befindet sich am Rand dieses Elements. Dieser ist am wenigsten von der Durchbiegung des Trägers betroffen und trägt daher nicht zu einer Durchbiegung des Sensorchip-Elements bei. Der Raum zwischen dem nichthaftenden Bereich des Sensorchip-Elements und dem Träger steht durch den Verbindungsbereich im Druckaustausch mit dem Druckraum und bewirkt eine stets gleich bleibende Kraft auf die Unterseite des Sensorchip-Elements. Durch die Befestigung am Rand ist das Sensorchip-Element so gelagert, dass es eine hohe Widerstandskraft gegen Erschütterungen aufweist.

Es hat sich gezeigt, dass die Signaldrift von etwa 0.1% der herkömmlichen Ausführungen etwa um das zehnfache verringert wird durch die erfindungsgemässe Klebung.

### Kurze Beschreibung der Zeichnungen

Im Folgenden wird die Erfindung anhand der Zeichnung näher erläutert. Es zeigen in schematischer Darstellung:
- Fig. 1: einen Öl gefüllten piezoresistiven Drucksensor nach dem Stand der Technik, im Querschnitt;
- Fig. 2: ein Sensorchip-Element auf einem Träger mit einer Klebung nach dem Stand der Technik;
- Fig. 3a: ein Sensorchip-Element nach Fig. 3 unter Druckbelastung;
- Fig. 3b: das Sensorchip-Element nach Fig. 3 unter Druckbelastung nach einiger Zeit;
- Fig. 4a: eine erfindungsgemässe Sensorchipklebung auf der Unterseite eines Sensorchip-Elements;
- Fig. 4b: eine alternative erfindungsgemässe Sensorchipklebung auf der Unterseite eines Sensorchip-Elements;
- Fig. 4c: eine weitere alternative erfindungsgemässe Sensorchipklebung auf der Unterseite eines Sensorchip-Elements;
- Fig. 5: ein Sensorchip-Element auf einem Träger mit einer erfindungsgemässen Sensorchipklebung unter Druckbelastung;
- Fig. 6: eine perspektivische Ansicht eines Trägers mit Angabe der erfindungsgemässen Sensorchipklebung;
- Fig. 7: ein erfindungsgemässer Drucksensor.

### Wege zur Ausführung der Erfindung

Sämtliche Bezugszeichen haben in allen Figuren die gleiche Bedeutung.

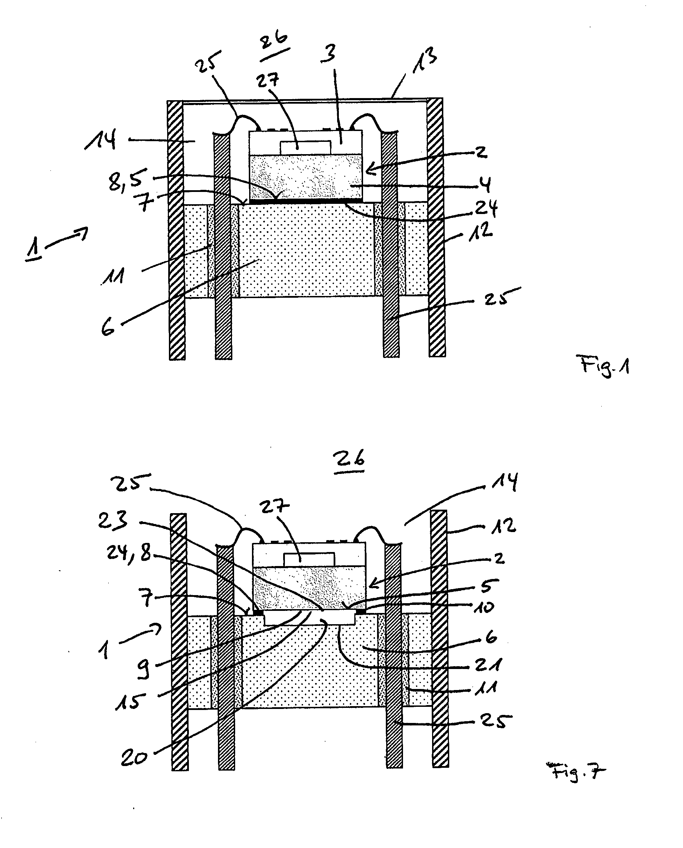

Die Fig. 1 zeigt in einer schematischen Darstellung einen Drucksensor 1 nach dem Stand der Technik. In einem Gehäuse 12 befindet sich ein piezoresistives Sensorchip-Element 2, das mit seiner Element-Unterseite 5 auf einem Träger 6 angebracht ist. Das Sensorchip-Element 2 umfasst in dieser Ausführung einen piezoresistiven Chip 3 auf einer blockförmigen Chipunterlage 4. Zwischen diesem Chip 3 und der Unterlage 4 wird eine Chipkavität 27 eingeschlossen. Der Chip 3 misst jeweils den Druckunterschied zwischen dem Referenzdruck in der Chipkavität 27 und dem von aussen auf den Chip 3 wirkenden Druck. Das Sensorchip-Element 2 wird von allen Seiten abgesehen von seiner Unterseite 5 von einem Druckmedium 14 umströmt und erzeugt bei Druckbeaufschlagung ein Messsignal, das durch Kontaktierungen 25 weitergeleitet wird. Diese verlaufen durch den Träger 6, der hier als Durchführung ausgestaltet ist. Eine Isolation 11 sorgt für die Abdichtung des Druckraums mit dem Druckmedium 14. Die Messsignale werden schliesslich in einem hier nicht dargestellten Auswertegerät weiter bearbeitet.

In dieser Ausführungsform ist das Gehäuse 1 mit einer Membran 13 gegen den Druckraum 26 geschlossen. Dadurch sind die Kontaktierungen 25 und das Sensorchip-Element 2 gegen mechanische und chemische Einflüsse vom Druckraum 26 her geschützt. Der Raum um das Sensorchip-Element 2 herum ist bei diesen Ausführungen in der Regel mit dem Druckmedium 14 Öl gefüllt, das durch die weiche Membran 13 stets denselben Druck aufweist wie der Druckraum 26. Andere, äquivalente Ausführungen weisen keine Membran 13 aus. Dadurch ist das Sensorchip-Element 2 direkt dem Druckmedium 14 des Druckraums 26 ausgesetzt.

Das Sensorchip-Element 2 weist eine Element-Unterseite 5 auf, die sich auf der Chip-Unterlage 4 gegenüber dem Chip 3 befindet. Mit dieser Element-Unterseite 5 ist es auf der Oberfläche 7 des Trägers 6 angebracht, die gegen den Druckraum 26 gerichtet ist. In dieser Ausführungsform nach dem Stand der Technik umfasst der Haftbereich 8, mit dem das Sensorchip-Element 2 auf dem Träger 6 haftet, die gesamte Fläche der Element-Unterseite 5. In der Regel wird für die Haftung eine Klebemasse 24 eingesetzt.

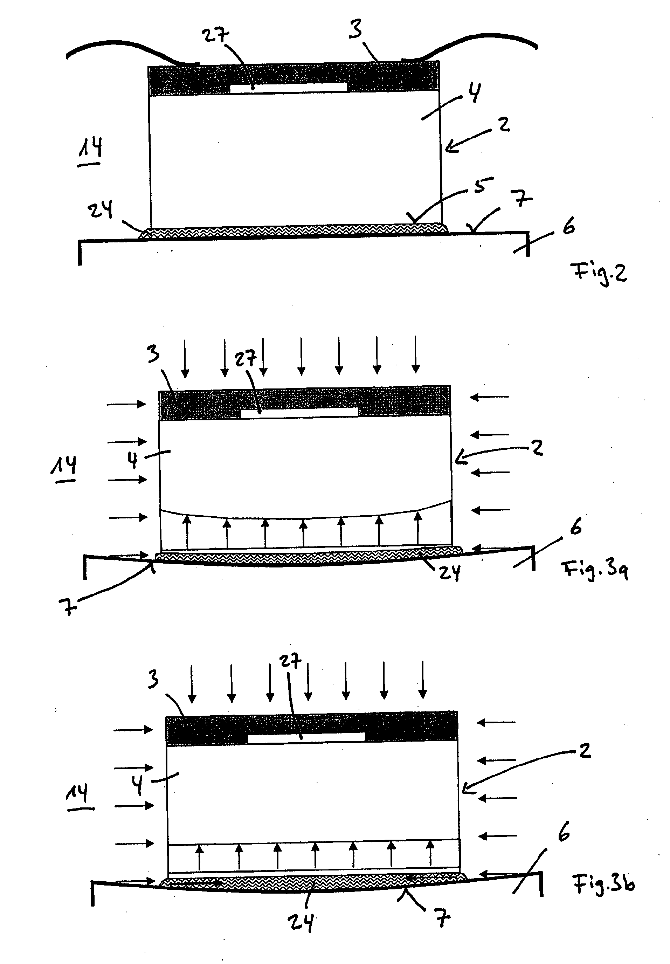

In Fig. 2 ist ein bekanntes Sensorchip-Element 2 nach Fig. 1 auf einem Träger 6 im Querschnitt dargestellt. Die Klebemasse 24 ist gleichmässig zwischen der Element-Unterseite und der Träger-Oberfläche aufgetragen. Diese Figur 2 entspricht einer Anordnung ohne Druckbeaufschlagung.

Fig. 3a und 3b zeigen dasselbe Sensorchip-Element 2 von Fig. 2 unter Druckbelastung, zum Zeitpunkt der Druckbeaufschlagung (Fig. 3a) und lange Zeit später (Fig. 3b). Da es sich bei dieser Erfindung um Langzeitdrucksensoren handelt, die viele Monate oder Jahre zuverlässig messen können, ohne ein "Reset" zu benötigen, kann die Zeit dazwischen entsprechend lang sein.

Die Pfeile um das Sensorchip-Element 2 zeigen die Druckbelastung des Druckmediums 14, das auf dieses wirkt. In beiden Figuren 3a und 3b ist der Träger 6 durch die Druckbelastung durchgebogen, was zu einer Krümmung der Träger-Oberseite 7 führt.

In Fig. 3a, zu Beginn der Druckbeaufschlagung, ist die Druckbelastung auf die Element-Unterseite 5 mittig geringer, weil die Klebemasse 24 diesen Bereich in Richtung Träger-Oberseite 7 zieht. Daher wird das Sensorchip-Element leicht verformt, was zu einer leichten Erhöhung des Messwertes führt, das vom Chip 3 ermittelt wird. Eine gestrichelte Linie auf diesem zeigt übertrieben deren Durchbiegung.

Der Druck wirkt auch seitlich auf die Klebemasse 24. Zusammen mit dem Unterdruck, der mittig unter der Element-Unterseite 5 entsteht, kriecht die Klebemasse 24 mit der Zeit langsam Richtung Zentrum, wie in Fig. 3b dargestellt. Der Druck auf die Element-Unterseite 5 verändert sich dadurch, und somit auch das Messsignal, bei gleichbleibendem Druck. Das Sensorchip-Element 2 entspannt sich und nähert sich wieder seiner Form an, die es ohne Druckaufschlag in Fig. 3 hatte. Die gleich langen Pfeile entlang eines Querschnitts des Sensorchip-Elements geben dies entsprechend an.

Sobald der Druck im Druckraum allerdings auf Umgebungsdruck sinkt und der Träger wieder seine ursprüngliche, ebene Form annimmt, drückt der Kleber in der Mitte, wo er sich in der Zwischenzeit angesammelt hatte, vermehrt gegen das Sensorchipelement und erzeugt somit ein Fehlsignal, das fälschlicherweise auf einen erhöhten Druck im Druckraum schliessen lässt.

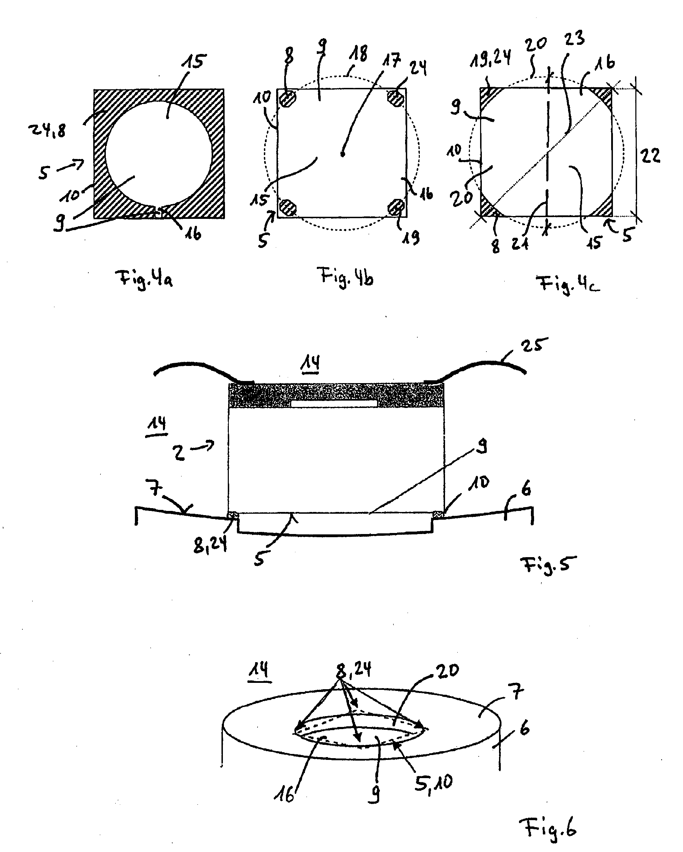

In den erfindungsgemässen Ausgestaltungen des Drucksensors haftet die Element-Unterseite 5 nicht vollständig am Träger 6 sondern nur in einem Bereich, welcher den zentralen Bereich ausschliesst. In Fig. 4a ist eine Element-Unterseite 5 angegeben mit einem äusseren Rand 10. Diese Element-Unterseite 5 innerhalb des Randes 10 ist in Fig. 4a in einen gestreift markierten möglichen Haftbereich 8 und einen nicht markierten Nichthaftbereich 9 eingeteilt. Während die Element-Unterseite 5 im gesamten Nichthaftbereich 9 keinesfalls an den Träger 6 haften darf, muss sie nicht zwingend im gesamten möglichen Haftbereich an den Träger 6 haften. Der tatsächliche Haftbereich 8 muss zwar innerhalb des in Fig. 4a gezeigten möglichen Haftbereichs erfolgen, muss diesen aber nicht vollständig bedecken, wie beispielhaft in den Fig. 4b und 4c gezeigt.

Erfindungsgemäss weist der Träger 6 mittig eine Vertiefung 20 auf. Dadurch ist gewährleistet, dass sich der Nichthaftbereich 9 bei der Montage nicht durch die Kapillarwirkung mit Kleber füllt. Überschüssiger Kleber, der allenfalls zu viel aufgetragen wurde, kann in die Vertiefung 20 abfliessen, ohne jedoch eine Haftung im Nichthaftbereich 9 zu bewirken. Erfindungsgemäss umfasst der Nichthaftbereich 9 mindestens einen Drittel, vorzugsweise mindestens die Hälfte der Element-Unterseite 5, welche eine mittig angeordnete Kreisfläche 15 definiert. Zudem umfasst der Nichthaftbereich 9 mindestens einen Verbindungsbereich 16 von dieser Kreisfläche 15 zum Rand 10 der Element-Unterseite 5. Dadurch ist gewährleistet, dass sich der Druck im Druckmedium 14 durch den Verbindungsbereich 16 in den Nichthaftbereich 9, insbesondere in den Raum bei der mittig angeordneten Kreisfläche 15 auf der Element-Unterseite 5 ausbreiten kann.

Die Kräfte, die in dieser Ausführung noch von den Haftbereichen 8 auf das Sensorchip-Element 2 wirken können, gehen aus Fig. 5 hervor. Fig. 5 zeigt einen Schnitt eines erfindungsgemässen Sensorchip-Elements 2 bei Druckbelastung. Die Krümmung des Trägers 6 ist stark übertrieben dargestellt. Da sich die Haftbereiche 8 nur in der Nähe des Randes 10 befinden und den mittleren Bereich aussparen, und da zusätzlich der Druck auch von innen, d.h. von der Mitte her auf die Verbindungen im Haftbereich 8 wirken, wirken kaum Kräfte auf das Sensorchip-Element 2, wodurch dieses kaum mehr verformt wird. Demnach sind diese vernachlässigbaren Kräfte auch nach langer Zeit kaum anders als zu Beginn der Druckbeaufschlagung, wodurch sich das Messsignal auch nach langer Zeit nicht ändert.

Entscheidend ist, dass sich der Nichthaftbereich 9 über eine mittig auf der Element-Unterseite 5 angeordnete Kreisfläche 15 erstreckt, welche mindestens einen Drittel der Gesamtfläche der Element-Unterseite 5 umfasst. Dadurch wird gewährleistet, dass bei einer Durchbiegung der Träger-Oberseite 7 kaum mehr Kräfte über den Haftbereich 8 auf das Sensorchip-Element 2 übertragen werden.

Zudem ist wichtig, dass das Druckmedium 14 mindestens einen Zugang durch einen Verbindungsbereich 16 zur mittig angeordneten Kreisfläche 15 aufweist, damit der Druck allseitig wirken kann.

Fig. 4b zeigt eine weitere erfindungsgemässe Anordnung des Haftbereichs 8. Erfindungsgemäss soll die Klebemasse 24 im Wesentlichen auf einer Kreislinie 18 angebracht sein, welche konzentrisch zu einer Sensorachse 17 verläuft. Da die Verformungen entlang solcher Kreislinien 18 überall gleich sind, sind die Kräfte auf die Klebemasse 24 in diesen Bereichen gleich. Je weiter aussen die Haftbereiche 8 sind, desto geringer sind die Kräfte. Vorzugsweise besteht der Haftbereich 8 aus diskreten Punkten oder diskreten Streckenabschnitten, sodass stets mindestens eine Verbindung zum Nichthaftbereich 9 gewährleistet ist.

Da das Sensorchip-Element 2 in der Regel rechteckig ausgestaltet ist, ist es von Vorteil, den Haftbereich 8 an Eckpunkten 19 der Element-Unterseite 5 anzubringen, wie auch in Fig. 4b und 4c dargestellt. Vorzugsweise sollte der Haftbereich 8 gesamthaft weniger als 20%, vorzugsweise weniger als 5% der Element-Unterseite 5 umfassen. Es hat sich gezeigt, dass dies vollständig ausreichend ist, um eine genügende Haftung zwischen Träger 6 und Sensorchip-Element 2 herzustellen.

Ursprünglich war der erfindungsgemässe Drucksensor 1 für Anwendungen ausgerichtet mit sehr hohen Drücken, insbesondere von Drücken mit über 50 bar. Typische Anwendungsbereiche finden sich in der Ozeanographie, bei der Förderung von Öl und Gas sowie beim Transport von Gas. Es hat sich aber gezeigt, dass auch Drucksensoren im Bereich von 1-5 bar bereits signifikante Verbesserungen erzielen, wenn der Drucksensor 1 erfindungsgemäss ausgestaltet ist.

Besonders vorteilhaft ist der erfindungsgemässe Drucksensor 1, wenn die Vertiefung 20 kreisrund mittig unter dem in der Regel rechteckigen Sensorchip-Element ausgestaltet ist, wie in Fig. 6 perspektivisch dargestellt. Eine solche Vertiefung 20 kann leicht als Bohrung angebracht werden. Erfindungsgemäss ist hier der Durchmesser 21 der Vertiefung 20 grösser als eine Kantenlänge 22 und kleiner als eine Diagonale 23 der rechteckigen Element-Unterseite 5. Dadurch ist gewährleistet, dass stets ein Verbindungsbereich 16 besteht, der eine Druckverbindung zum Nichthaftbereich 9 herstellt, wie aus Fig. 4c und Fig. 5 hervorgeht.

Der Nichthaftbereich 9 ist demnach die gemeinsame Fläche der runden Vertiefung 20 und der rechteckigen Element-Unterfläche 5. Dieser ist in Fig. 4c dargestellt. Der Haftbereich erstreckt sich über die Ecken 19 der rechteckigen Element-Unterfläche 5, die ausserhalb der Bohrung 20 liegen. Ein geeigneter Kleber 24 kann flächig oder punktuell auf die Element-Unterfläche 5 oder auf den Träger aufgegeben werden, bevor das Sensorchip-Element 2 auf den Tröger 6 gebracht wird. Dank der Vertiefung 20 ist der erforderliche Nichthaftbereich sowie ein Zugang des Druckmediums 14 zur Sensorchip-Element Unterseite 5 stets gewährleistet.

Vorzugsweise haftet das Sensorchip-Element 2 durch eine Klebemasse 24 auf dem Träger 6. Eine Klebemasse 24 stellt ein Medium dar, das an beiden Oberflächen haftet. Es hat sich herausgestellt, dass weiche, elastische Kleber 24 bessere Resultate liefern als harte Kleber. Insbesondere Klebemassen 24 von einer Streckdehnung von mindestens 100%, vorzugsweise von 200% übertragen weniger Kräfte und sind daher anderen, steifen Klebemassen 24 vorzuziehen. Dies liegt daran, dass die Klebeschichten in der Regel sehr dünn aufgetragen werden. Tangentiale Verschiebungen sind daher auch bei dünnen Schichten möglich.

Fig. 7 zeigt schliesslich einen erfindungsgemässen Drucksensor 1 mit Vertiefung 20, beispielsweise entlang einer Diagonalen 23 des Sensorchip-Elements 2 gem. Fig. 4c. Er kann wie dargestellt ohne Membrane 13 oder, wie in Fig. 1 dargestellt, mit Membrane 13 ausgestaltet sein.

### Bezugszeichenliste

- 1: Drucksensor, Sensor
- 2: Sensorchip-Element, Element
- 3: Chip
- 4: Chip-Unterlage
- 5: Element-Unterseite, Unterseite
- 6: Träger, Durchführung
- 7: Träger-Oberseite
- 8: Haftbereich
- 9: Nichthaftbereich
- 10: Äusserer Rand der Unterseite
- 11: Isolation
- 12: Gehäuse
- 13: Membran
- 14: Druckmedium, Druckraum
- 15: Mittig angeordnete Kreisfläche
- 16: Verbindungsbereich
- 17: Sensorachse
- 18: Kreislinie, konzentrisch zur Sensorachse
- 19: Eckpunkte der Unterseite
- 20: Vertiefung, Bohrung
- 21: Durchmesser der Vertiefung oder der Bohrung
- 22: Kantenlänge der Element-Unterseite
- 23: Diagonale der Element-Unterseite
- 24: Klebemasse
- 25: Kontaktierungen
- 26: Druckraum
- 27: Abgeschlossene Chipkavität

## Patentansprüche

1. Drucksensor umfassend ein piezoresistives Sensorchip-Element (2) mit abgeschlossener Chipkavität (27) zum Messen des Drucks eines das Element (2) umspülenden Druckmediums (14), mit einer Element-Unterseite (5), sowie einen Träger (6) mit einer Träger-Oberseite (7), auf der das Sensorchip-Element (2) an seiner Unterseite (5) befestigt ist, wobei diese Unterseite (5) einen Haftbereich (8) und einen äusseren Rand (10) aufweist, und wobei die Unterseite (5) im Haftbereich (8) an der Träger-Oberseite (7) haftet, wobei die Unterseite (5) einen Nichthaftbereich (9) aufweist, in welchem die Unterseite (5) nicht an der Träger-Oberseite (7) haftet und wobei sich der Nichthaftbereich (9) mindestens über eine mittig auf der Unterseite (5) angeordnete Kreisfläche (15) erstreckt, welche einen Drittel der Gesamtfläche der Element-Unterseite (5) umfasst, und wobei der Nichthaftbereich (9) mindestens einen Verbindungsbereich (16) von der Kreisfläche (15) zum Rand (10) der Unterseite (5) umfasst, sodass sich der Druck im Druckmedium (14) durch den Verbindungsbereich (16) in einen Raum unter dem Nichthaftbereich (9) auf der Element-Unterseite (5) ausbreiten kann, **dadurch gekennzeichnet, dass** der Träger (6) mittig unter dem Sensorchip-Element (2) eine Vertiefung (20) aufweist.

2. Drucksensor nach Anspruch 1, **dadurch gekennzeichnet, dass** die Vertiefung (20) eine Bohrung ist.

3. Drucksensor nach Anspruch 1 oder 2, **dadurch gekennzeichnet, dass** die Element-Unterseite (5) rechteckig ist und dass der Durchmesser der Vertiefung (20) grösser als eine Kantenlänge (22) und kleiner als eine Diagonale (23) der Element-Unterseite (5) ist.

4. Drucksensor nach einem der vorhergehenden Ansprüche, **dadurch gekennzeichnet, dass** der Nichthaftbereich (9) mindestens den Bereich der Vertiefung (20) umfasst, der der Element-Unterseite (5) gegenüberliegt.

5. Drucksensor nach einem der vorhergehenden Ansprüche, **dadurch gekennzeichnet, dass** sich die Vertiefung (20) mindestens über eine mittig auf der Unterseite (5) angeordnete Kreisfläche (15) erstreckt, welche einen Drittel der Gesamtfläche der Element-Unterseite (5) umfasst, und wobei die Vertiefung (20) mindestens einen Verbindungsbereich (16) von der Kreisfläche (15) über den Rand (10) der Unterseite (5) hinaus umfasst, sodass sich der Druck im Druckmedium (14) durch den Verbindungsbereich (16) in einen Raum unter dem Nichthaftbereich (9) auf der Element-Unterseite (5) ausbreiten kann.

6. Drucksensor nach einem der vorhergehenden Ansprüche, **dadurch gekennzeichnet, dass** der Haftbereich (8) im Wesentlichen auf einer Kreislinie (18) angebracht ist, welche konzentrisch zu einer Sensorachse (17) verläuft.

7. Drucksensor nach einem der vorhergehenden Ansprüche, **dadurch gekennzeichnet, dass** der Haftbereich (8) aus diskreten Punkten oder diskreten Streckenabschnitten besteht.

8. Drucksensor nach einem der vorhergehenden Ansprüche, **dadurch gekennzeichnet, dass** der Haftbereich (8) an Eckpunkten (19) der Unterseite (5) angebracht sind.

9. Drucksensor nach einem der vorhergehenden Ansprüche, **dadurch gekennzeichnet, dass** der Haftbereich (8) gesamthaft weniger als 20%, vorzugsweise weniger als 5% der Unterseite (5) umfasst.

10. Drucksensor nach einem der vorhergehenden Ansprüche, **dadurch gekennzeichnet, dass** der Sensor ein Hochdrucksensor ist, geeignet zum Messen von Drücken von über 50 bar.

11. Drucksensor nach einem der vorhergehenden Ansprüche, **dadurch gekennzeichnet, dass** das Sensorchip-Element (2) durch eine Klebemasse (24) auf dem Träger (6) haftet.

12. Drucksensor nach Anspruch 11, **dadurch gekennzeichnet, dass** die Klebemasse (24) eine Streckdehnung von mindestens 100%, vorzugsweise von 200% aushält.

## Claims

1. A pressure sensor comprising a piezoresistive sensor chip element (2) having a closed chip cavity (27) for measuring the pressure of a pressure medium (14) flowing around the element (2), and having an element lower surface (5), as well as a substrate (6) having a substrate upper surface (7) to which the sensor chip element (2) is attached at its lower surface (5) wherein said lower surface (5) has an adhesion area (8) and an outer edge (10), and wherein the lower surface (5) adheres to the substrate upper surface (7) in the adhesion area (8), said lower surface (5) having a non-adhesion area (9) in which the lower surface (5) does not adhere to the substrate upper surface (7) and wherein said non-adhesion area (9) extends at least over a circular area (15) arranged centrally on the lower surface (5), said circular area comprising one third of the total area of the element lower surface (5), and wherein said non-adhesion area (9) comprises one or more connection area(s) (16) from the circular area (15) to the edge (10) of the lower surface (5) so that the pressure in the pressure medium (14) can spread through the connection area (16) into a space under the non-adhesion area (9) on the element lower surface (5) **characterized in that** the substrate (6) has a recess (20) located centrally under the sensor chip element (2).

2. A pressure sensor according to claim 1 **characterized in that** said recess (20) is a bore.

3. A pressure sensor according to claim 1 or 2 **characterized in that** the element lower surface (5) is rectangular in shape and **in that** the diameter of the recess (20) is greater than an edge length (22) and smaller than the diagonal (23) of the element lower surface (5).

4. A pressure sensor according to any of the preceding claims **characterized in that** the non-adhesion area (9) comprises at least the area of the recess (20) that faces the lower element surface (5).

5. A pressure sensor according to any of the preceding claims **characterized in that** said recess (20) extends at least over a circular area (15) arranged centrally on the lower surface (5) and comprising one third of the total area of the element lower surface (5), and wherein said recess (20) comprises one or more connection area(s) (16) from the circular area (15) beyond the edge (10) of the lower surface (5) so that the pressure in the pressure medium (14) can spread through the connection area (16) into a space under the non-adhesion area (9) on the element lower surface (5).

6. A pressure sensor according to any of the preceding claims **characterized in that** the adhesion area (8) is substantially arranged along the circumference of a circle (18) extending concentrically to one sensor axis (17).

7. A pressure sensor according to any of the preceding claims **characterized in that** the adhesion area (8) consists of discrete points or discrete sections.

8. A pressure sensor according to any of the preceding claims **characterized in that** the adhesion area (8) is attached to corner points (19) of the lower surface (5).

9. A pressure sensor according to any of the preceding claims **characterized in that** the adhesion area (8) in total comprises less than 20%, preferably less than 5% of the lower surface (5).

10. A pressure sensor according to any of the preceding claims **characterized in that** said sensor is a high pressure sensor suitable for measuring pressures of more than 50 bar.

11. A pressure sensor according to any of the preceding claims **characterized in that** the sensor chip element (2) adheres to the substrate (6) by means of an adhesive paste (24).

12. A pressure sensor according to claim 11 **characterized in that** said adhesive paste (24) withstands an elongation at yield of at least 100%, preferably 200%.

## Revendications

1. Un capteur de pression comprenant un élément de puce de capteur piézorésistif (2) ayant une cavité de puce fermée (27) pour mesurer la pression d'un fluide de pression (14) coulant autour l'élément (2) et ayant une surface inférieure d'élément (5), ainsi qu'un substrat (6) ayant une surface supérieure de substrat (7) à laquelle est attaché l'élément de puce de capteur (2) à sa surface inférieure (5) où ladite surface inférieure (5) a une zone d'adhérence (8) et un bord extérieur (10), et où la surface inférieure (5) adhère à la surface supérieure de substrat (7) dans la zone d'adhérence (8), ladite surface inférieure (5) ayant une zone de non-adhérence (9) dans laquelle la surface inférieure (5) n'adhère pas à la surface supérieure de substrat (7), et où ladite zone de non-adhérence (9) s'étend sur au moins une zone circulaire (15) se situant centralement sur la surface inférieure (5), ladite zone circulaire comprenant un tiers de la surface totale de la surface inférieure d'élément (5), et où ladite zone de non-adhérence (9) comprend une ou plusieurs zone(s) de connexion (16) de la zone circulaire (15) au bord (10) de la surface inférieure (5) afin que la pression dans le fluide de pression (14) peut se propager à travers la zone de connexion (16) dans un espace au-dessous la zone de non-adhérence (9) sur la surface inférieure d'élément (5) **caractérisé en ce que** le substrat (6) comporte un évidement (20) disposé centralement sous l'élément de puce de capteur (2).

2. Un capteur de pression selon la revendication 1 **caractérisé en ce que** ledit évidement (20) et un alésage.

3. Un capteur de pression selon la revendication 1 ou 2 **caractérisé en ce que** la surface inférieure d'élément (5) est rectangulaire et **en ce que** le diamètre dudit évidement (20) est supérieur à une longueur d'arête (22) et inférieur à la diagonale (23) de la surface inférieure d'élément (5).

4. Un capteur de pression selon l'une quelconque des revendications précédentes **caractérisé en ce que** ladite zone de non-adhérence (9) comprend au moins la zone dudit évidement (20) qui fait face à la surface inférieur d'élément (5).

5. Un capteur de pression selon l'une quelconque des revendications précédentes **caractérisé en ce que** ledit évidement (20) s'étend sur au moins une zone circulaire (15) située centralement sur la surface inférieure (5), ladite zone circulaire comprenant un tiers de la surface totale de la surface inférieure d'élément (5), et où ledit évidement (20) comprend une ou plusieurs zone(s) de connexion (16) s'étendant de la zone circulaire (15) au-delà du bord (10) de la surface inférieure (5) afin que la pression dans le fluide de pression (14) peut se propager à travers la zone de connexion (16) dans un espace au-dessous la zone de non-adhérence (9) sur la surface inférieure d'élément (5).

6. Un capteur de pression selon l'une quelconque des revendications précédentes **caractérisé en ce que** la zone d'adhérence (8) est disposée sensiblement le long de la circonférence d'un cercle (18) s'étendant de façon concentrique par rapport à un axe de capteur (17).

7. Un capteur de pression selon l'une quelconque des revendications précédentes **caractérisé en ce que** la zone d'adhérence (8) se compose des points distincts ou sections de ligne distinctes.

8. Un capteur de pression selon l'une quelconque des revendications précédentes **caractérisé en ce que** la zone d'adhérence (8) est attachée à des points d'angle (19) de la surface inférieure (5).

9. Un capteur de pression selon l'une quelconque des revendications précédentes **caractérisé en ce que** la zone d'adhérence (8) comprend au total moins de 20%, de préférence moins de 5% de la surface inférieure (5).

10. Un capteur de pression selon l'une quelconque des revendications précédentes **caractérisé en ce que** ledit capteur et un capteur haute pression adaptée à la mesure des pressions de plus de 50 bar.

11. Un capteur de pression selon l'une quelconque des revendications précédentes **caractérisé en ce que** ledit élément de puce de capteur (2) adhère au substrat (6) au moyen d'une masse collante (24).

12. Un capteur de pression selon la revendication 11 **caractérisé en ce que** ladite masse collante (24) résiste à un allongement d'au moins 100%, de préférence 200%.
